# FASCICULE DE BREVET EUROPEEN

(11) **EP 1 543 355 B1**
(45) Date de publication et mention de la délivrance du brevet: **25.07.2007**
(21) Numéro de dépôt: 03769556.6
(22) Date de dépôt: 02.09.2003
(51) Int. Cl.: H01L 27/146

(54) **MICROSYSTEME OPTIQUE ET PROCEDE DE FABRICATION**
OPTISCHES MIKROSYSTEM UND HERSTELLUNGSVERFAHREN
OPTICAL MICROSYSTEM AND METHOD FOR MAKING SAME

(30) Priorité: 03.09.2002 FR 0210899
(43) Date de publication de la demande: 22.06.2005
(73) Titulaire: E2V SEMICONDUCTORS, 38120 Saint Egreve (FR)
(72) Inventeur: Rommeveaux, Philippe, Thales Intellectual Property, F-94117 Arcueil Cedex (FR)
(74) Mandataire: Guérin, Michel
(86) Numéro de dépôt international: PCT/FR2003/002629
(87) Numéro de publication internationale: WO 2004/023166

(56) Documents cités:
- EP-A- 1 102 321
- EP-A- 1 122 790
- FR-A- 2 829 292
- US-A- 4 956 687
- US-A- 6 051 867
- PATENT ABSTRACTS OF JAPAN vol. 011, no. 108 (E-495), 4 avril 1987 (1987-04-04) & JP 61 255063 A (MATSUSHITA ELECTRIC IND CO LTD), 12 novembre 1986 (1986-11-12)

## Description

L'invention concerne les microsystèmes optiques à matrice électronique monolithique de points d'image.

Par microsystèmes optiques, on entend ici des systèmes de capteurs d'image ou d'affichage d'image formés à partir d'une puce monolithique (en principe en silicium) sur laquelle on a gravé d'une part un réseau matriciel de points d'image en lignes et en colonnes et d'autre part des circuits électroniques de commande de ce réseau matriciel ; une structure optique de formation d'image est placée en contact étroit avec la puce de silicium, l'ensemble de la puce et de la structure optique accolée formant le microsystème optique.

Dans le cas d'un capteur d'image, les points d'image en réseau matriciel sont des éléments photosensibles générant des signaux électriques en fonction de la lumière reçue par l'élément ; la structure optique de formation d'image est alors un système (lentille de focalisation en principe) capable de projeter une image globale à détecter sur le réseau matriciel d'éléments photosensibles formé sur la puce monolithique.

Inversement, dans le cas d'un afficheur d'image, les points sont des éléments électro-optiques émettant, ou transmettant, ou réfléchissant de la lumière en la modulant en fonction d'un signal électrique qui est appliqué à l'élément ; la structure optique de formation d'image est alors une structure capable de transformer en une image visible, réelle ou virtuelle, les signaux électriques appliqués au réseau matriciel d'éléments électro-optiques formé sur la puce.

Ces microsystèmes optiques sont destinés à des applications où la miniaturisation est essentielle. On peut citer par exemple des modulateurs optiques miniatures destinés à la projection de signaux vidéo, des viseurs d'appareils photographiques ou de caméras, des écrans d'affichage et des caméras miniatures sur des appareils de téléphonie mobile, etc.

Le coût de ces systèmes est en grande partie dû au coût de fabrication de la puce de circuit intégré. Ce coût résulte lui-même d'une part de la surface de silicium utilisée pour la fabrication d'une puce, et d'autre part de la nature et du nombre des opérations effectuées pour la fabrication. En particulier, le coût résulte du caractère collectif ou non collectif des opérations, en ce sens que certaines opérations sont fabriquées collectivement sur une tranche de silicium (ou "wafer" en anglais) comportant un certain nombre de puces individuelles, alors que d'autres opérations doivent être effectuées individuellement sur chaque puce après découpage de la tranche en puces individuelles. Si certaines opérations ne peuvent pas être effectuées collectivement, le coût est augmenté. Pour les opérations collectives, si la surface de silicium utilisée est plus importante pour une puce, on ne peut mettre qu'un plus petit nombre de puces sur une tranche, augmentant de ce fait aussi le coût des opérations par puce.

L'adjonction à la puce électronique d'une structure optique pose des problèmes de coût analogues puisque d'une part des opérations supplémentaires sont forcément nécessaires pour réaliser cette structure, et d'autre part la nécessité d'adjoindre à la puce un système optique peut modifier et rendre plus complexes ou plus coûteuses les opérations nécessaires pour la puce électronique elle-même.

Le document US 4,965,687 décrit un dispositif avec des vias qui s'étendent jusqu'à la force arrière de la puce électronique. Le document EP-A-1 122 790 décrit un dispositif d'image avec des vias en-dessous des pixels.

Un but de l'invention est donc d'améliorer le rapport entre les performances et le coût de fabrication d'un microsystème optique.

Selon l'invention, on propose un procédé de fabrication d'un microsystème optique à matrice électronique monolithique, dans lequel on fabrique collectivement, sur la face avant d'une tranche semiconductrice (en principe en silicium) d'une épaisseur d'une ou plusieurs centaines de micromètres au moins, N réseaux matriciels de points d'image et des circuits associés à chaque réseau, pour réaliser sur cette tranche N puces électroniques monolithiques identiques, avec sur au moins un côté de chaque réseau un ensemble de plages de contact électrique pour la connexion de la puce correspondante avec l'extérieur, on fabrique collectivement et on place en contact étroit avec la face avant de la tranche semiconductrice une plaque servant à la constitution collective de N structures optiques de formation d'image, identiques, chaque structure optique de formation d'image recouvrant une puce respective et étant apte à former une image globale en correspondance avec l'ensemble du réseau matriciel de la puce respective, on ouvre à l'arrière de la tranche semiconductrice et sur toute l'épaisseur de celle-ci des trous allant jusqu'aux plages de contact de la face avant, on utilise ces trous pour établir une connexion électrique conductrice avec les plages de contact à partir de la face arrière de la tranche, et, seulement après ces différentes opérations, on divise la tranche en N microsystèmes optiques individuels, la séparation entre les puces et la séparation entre les structures optiques recouvrant les puces s'effectuant selon les mêmes lignes de découpe.

Le microsystème optique selon l'invention comprend donc l'association étroite d'une puce électronique monolithique d'une épaisseur d'une ou plusieurs centaines de micromètres, portant sur sa face avant un réseau matriciel de points d'image et des plages de contact électrique, et d'une structure optique 7 formation d'une image globale correspondant au réseau, la structure optique comportant une plaque placée contre la face avant de la puce, avec des contacts électriques à l'arrière de la puce et des vias conducteurs entre ces contacts électriques de la face arrière et les plages de contact de la face avant, pour l'accès au réseau matriciel.

Dans le cas d'un micro-afficheur d'image utilisant comme structure optique associée une cavité remplie de cristal liquide et fermée par une plaque comportant une contre-électrode, le cristal liquide étant situé entre la puce et cette plaque, on prévoit en outre que la puce comprend un perçage de remplissage de la cavité par la face arrière de la puce, s'étendant de la face arrière à la face avant de la puce, ce perçage étant fermé par un bouchon d'obturation. Ce perçage est formé comme les trous d'accès électriques qui traversent l'épaisseur de la puce et qui permettent l'accès électrique au réseau matriciel par la face arrière de la puce.

Les trous sont formés en pratique par gravure plasma anisotrope, cette technique permettant de former dans le silicium des trous de quelques dizaines de micromètres de diamètre ou de côté, sur plusieurs centaines de micromètres de profondeur. On peut envisager aussi des techniques de perçage par laser ou par ultrasons.

De préférence, le procédé de fabrication comporte une étape de collage de la puce avec la structure optique de formation d'image ; cette étape peut comporter la formation d'un cordon de scellement entourant chaque puce et servant à assurer ce collage ; ce cordon est déposé en lignes et en colonnes au stade de fabrication collective, sur la tranche semiconductrice ou sur la plaque destinée à constituer les structures optiques ; à la fin des étapes de fabrication collective, la tranche et la plaque sont découpées selon des lignes et des colonnes s'étendant dans la direction des cordons de scellement et passant de préférence par le milieu de la largeur de ceux-ci.

D'autres caractéristiques et avantages de l'invention apparaîtront à la lecture de la description détaillée qui suit et qui est faite en référence aux dessins annexés dans lesquels :
- la figure 1 et la figure 2 représentent en vue de dessus le principe de la superposition décalée d'un réseau de puces électroniques et d'un réseau de structures optiques dans une fabrication collective ;
- la figure 3 et la figure 4 représentent, respectivement en vue de dessus et en coupe latérale, un microsystème optique individuel résultant de la découpe de tranches après fabrication collective ;
- la figure 5 représente les marges à respecter pour établir le décalage entre les puces et les systèmes optiques lors de la découpe des tranches ;
- la figure 6 représente une structure de microsystème optique selon l'invention ;
- la figure 7 représente la configuration de cordons de scellement entre puces et systèmes optiques et les lignes de découpe s'étendant suivant la ligne de milieu de la largeur des cordons ;
- la figure 8 représente la manière de réaliser un accès électrique à une contre-électrode formée sur la structure optique.

L'invention sera décrite essentiellement à propos d'un micro-afficheur d'image à cristal liquide pour laquelle elle est particulièrement intéressante.

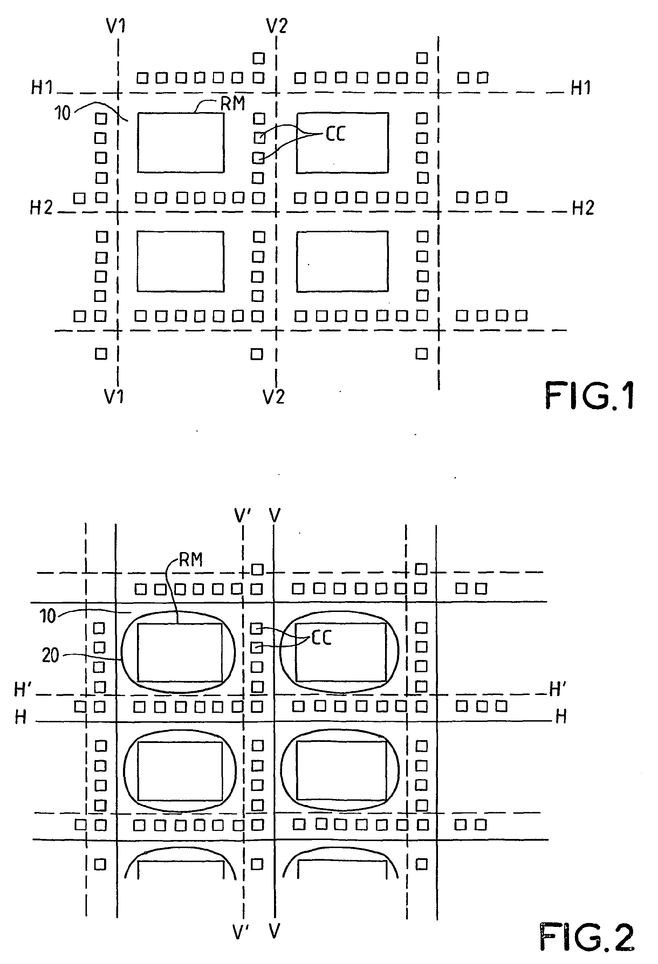

Pour mieux faire comprendre les problèmes posés par la fabrication collective d'un microsystème optique, et dans le cas présent un micro-afficheur à cristal liquide, on a représenté schématiquement sur la figure 1, en vue de dessus, une tranche de silicium (ou plus généralement un substrat de circuit intégré) sur la face avant de laquelle on a fabriqué collectivement N circuits intégrés identiques, correspondant chacun à un des micro-afficheurs à réaliser. Après les opérations de fabrication collective, effectuées sur la tranche, cette dernière est destinée à être séparée en puces individuelles selon des lignes droites tracées en pointillés sur la figure 1. Une puce individuelle monolithique est délimitée par un réseau de deux lignes pointillées horizontales adjacentes H1H1 et H2H2 et deux lignes pointillées verticales adjacentes V1V1 et V2V2.

Une puce individuelle 10 comporte un réseau matriciel de points d'image RM, des circuits périphériques autour de ce réseau, et des plages de contact métalliques CC à la périphérie de la puce sur au moins un côté de la puce, mais en pratique sur deux côtés lorsqu'il y a un nombre important de contacts à placer (plusieurs dizaines par exemple).

D'une manière classique, dans la fabrication d'une puce de circuit intégré, les plages de contact électriques CC sont destinés à être raccordées à l'extérieur par des fils soudés sur ces plages (technique dite "wire-bonding").

Pour constituer à partir de cette puce un microsystème optique comportant à la fois une puce et une structure optique de formation d'image, on souhaite, dans la mesure du possible, fabriquer collectivement la structure optique à partir d'une tranche intégrant N structures comme on fabrique collectivement la puce à partir d'une tranche de silicium comprenant N puces.

Cette fabrication se heurte cependant à des obstacles dont la présente invention cherche à minimiser les conséquences.

Un obstacle particulier est dû à la nécessité de laisser libre l'accès aux plages de contact électrique CC pour permettre d'y souder des fils.

Sur la figure 2, on a supposé que la structure optique est fabriquée collectivement sur une tranche spécifique qu'on vient rapporter (par collage, soudage ou autre) sur la tranche de silicium. Une structure optique individuelle 20, correspondant à une puce 10, a été figurée symboliquement sous forme d'un ovale situé au-dessus du réseau matriciel 20. Pour un micro-afficheur à cristal liquide, la structure optique de formation d'image 20 comprend essentiellement une cavité remplie de cristal liquide et une électrode transparente déposée sur une plaque de verre, qui permettent de convertir directement les signaux électriques du réseau matriciel en une image globale à afficher. Dans le cas d'un capteur d'image la structure serait constituée par exemple par une lentille projetant sur le réseau matriciel l'image complète à détecter.

Pour que les plages de contact électriques CC restent dégagées en vue de la soudure ultérieure de fils de connexion après la découpe en microsystèmes individuels, on comprend qu'il faut découper la tranche de structures optiques selon un réseau de lignes horizontales et verticales qui ne sont pas identiques aux lignes de découpe de la puce : si la puce 10 est découpée à droite par une ligne verticale VV et en bas par une ligne horizontale HH, la structure optique correspondante devra être découpée à droite par une ligne V'V' décalée par rapport à la ligne VV et en bas par une ligne H'H' décalée par rapport à la ligne HH. Les plages de contact sont situées d'une part entre les lignes HH et H'H' et d'autre part entre les lignes VV et V'V'. L'ensemble du réseau de lignes et de colonnes de découpe des structures optiques est un réseau décalé par rapport au réseau de lignes et de découpes des puces.

La fabrication collective du microsystème par intégration d'une tranche de structures optiques sur la tranche de silicium avant découpe de ces tranches en N microsystèmes individuels est donc rendue difficile et coûteuse à cause de cette opération de découpe en deux temps : découpe par la face supérieure, découpe par la face inférieure, selon deux réseaux différents de lignes et de colonnes.

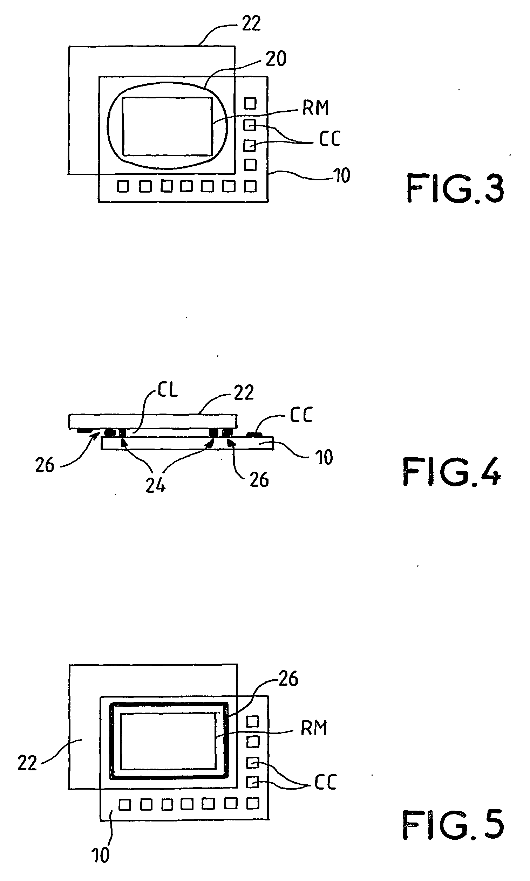

La figure 3 montre un microsystème optique tel qu'il résulte de cette double découpe, montrant la superposition décalée entre la plaquette optique 22 issue de la découpe de la tranche de structures optiques et la puce 10 issue de la découpe de la tranche de silicium, les contacts CC de la puce n'étant pas recouverts par la plaquette optique 22.

La figure 4 représente une vue latérale du microsystème, montrant également ce décalage entre les bords latéraux de la puce et les bords latéraux de la plaquette optique 22. Sur cette figure 4, correspondant au cas d'un afficheur à cristal liquide, on a représenté une cavité remplie de cristal liquide CL, cette cavité étant formée entre la face avant de la puce de silicium 10 (la face avant étant celle sur laquelle on a formé le réseau matriciel) et la plaquette 22. La cavité recouvre tout le réseau matriciel RM. Des entretoises 24 peuvent être prévues pour définir l'épaisseur de la cavité. Un cordon étanche de scellement 26 (en principe en résine époxy) fait le tour de toute la cavité pour la fermer hermétiquement tout en collant la tranche de silicium sur la tranche de structures optiques au niveau de chaque puce.

La figure 5 représente en vue dessus la position du cordon de scellement 26 autour de la cavité qui surplombe le réseau matriciel RM. On peut constater que la fabrication pratique d'un tel système oblige à prévoir :
- une marge d'espacement entre le réseau matriciel RM et le cordon de soudure 26 ;
- une marge d'espacement entre le cordon de soudure 26 et le bord de la plaquette optique 22 ;
- une marge d'espacement entre le bord de la plaquette optique et les plages de contact CC ; cette marge, de valeur importante, est nécessaire en particulier pour l'outillage de soudure de fils sur les plages de contact CC ;
- une marge d'espacement entre les plages de contact CC et le bord de la plaquette de silicium.

Ces marges augmentent d'autant la surface de puce nécessaire pour un réseau matriciel RM de dimension donnée et augmentent d'autant le coût du microsystème à performance donnée.

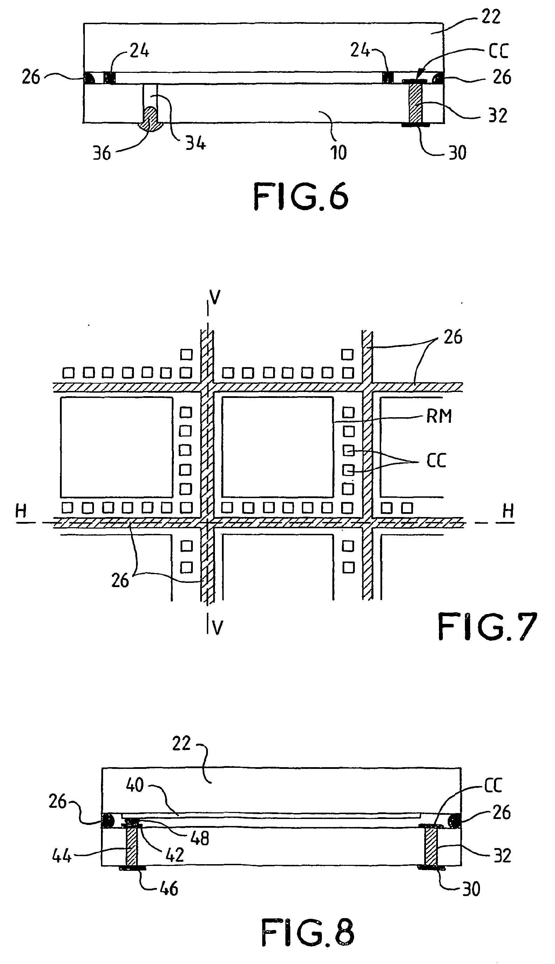

La figure 6 représente en coupe la structure de principe du microsystème selon l'invention.

La puce de silicium 10 et la plaquette optique 22 sont exactement superposées sans décalage latéral. Les plages de contact CC sur la face avant de la puce sont électriquement reliées à des plages de contact respectives 30 sur la face arrière de la puce par des vias conducteurs respectifs 32 traversant toute l'épaisseur de la puce, cette épaisseur étant classiquement de plusieurs centaines de micromètres et en tout cas d'au moins 70 micromètres. L'épaisseur mentionnée ici est donnée par comparaison avec des capteurs d'image formés sur du silicium aminci à une épaisseur de l'ordre de 10 micromètres ou moins, qui nécessitent des opérations délicates, en particulier un report sur un substrat de soutien et un rodage, et que la présente invention ne concerne pas, que ce soit pour des capteurs d'image ou a fortiori pour des afficheurs.

Dans l'exemple représenté, qui est un afficheur à cristaux liquides, la cavité remplie de cristal liquide CL est fermée en haut par la plaquette 22 qui est de préférence une plaquette de verre, et sur les côtés par un cordon de scellement 26 qui l'entoure complètement et qui suit exactement la périphérie de la puce et de la plaquette sans marge d'espacement entre le cordon 26 et le bord de la plaquette (ou de la puce) ou à la rigueur avec une très faible marge. Des entretoises 24 peuvent être prévues pour définir l'espacement entre la puce et la plaquette optique 22 (ces entretoises pourraient être noyées dans le cordon de scellement).

La structure optique de formation d'image est constituée par la plaquette 22 et la cavité dont elle constitue une paroi principale.

Les marges d'espacement qui étaient nécessaires dans la réalisation représentée à la figure 5 ne sont plus nécessaires. Une surface de puce proportionnellement beaucoup plus importante peut être affectée au réseau matriciel.

Les plages de contact CC peuvent être réparties, si on le désire ou si on en a besoin, sur les quatre côtés de la puce, ce qui n'aurait pas été possible avec une configuration telle que celle de la figure 5 avec décalage entre puce et plaquette optique.

Très avantageusement, on prévoit en outre, pour un afficheur à cristal liquide, un trou 34 de remplissage de cristal liquide à travers l'épaisseur de la puce de silicium. Le trou est fait soit en même temps que les trous des vias de contact 32, soit postérieurement. Ce trou 34 est bouché, après remplissage de la cavité par un cristal liquide, par un bouchon 36 de colle, par exemple de la colle polymérisable par ultra-violets. Le remplissage et le bouchage ont lieu pendant la fabrication sur tranche, avant division de la tranche en microsystèmes individuels, ce qui est particulièrement avantageux notamment du point de vue de la pureté du cristal liquide introduit (minimisation des impuretés lors du travail sur tranches). Le remplissage est fait après avoir mis la tranche de microsystèmes sous vide pendant plusieurs heures.

Avec ce trou de remplissage, il n'est pas nécessaire de prévoir que le cordon de scellement 26 est interrompu sur une partie de sa périphérie pour autoriser le remplissage avant de refermer la partie interrompue du cordon de scellement.

Les trous dans le silicium épais, pour les vias de contact ou pour l'orifice de remplissage, peuvent être faits par gravure ionique réactive sous plasma. On sait faire des trous de quelques dizaines de micromètres de diamètre ou de largeur sur plusieurs centaines de micromètres de profondeur, et cela convient bien. Les plages de contact CC ont une largeur légèrement supérieure à la largeur du trou, afin que le trou débouche avec certitude à l'arrière du plot de contact. Le trou de remplissage peut être de diamètre plus important que les vias de connexion électrique si les caractéristiques du cristal liquide l'exigent ; il ne débouche pas sur une plage de contact..

Sur la face arrière de la puce, on peut déposer et graver une couche conductrice formant des contacts 30 reliés aux vias conducteurs 32. Cette couche peut d'ailleurs aussi servir à établir un réseau d'interconnexions à l'arrière de la puce. Les contacts 30 peuvent être utilisés classiquement pour la connexion avec l'extérieur de la puce, soit par l'intermédiaire de fils soudés, soit par report direct sur un substrat ayant des plages de contact en regard des contacts 30 et soudure entre la puce et le substrat. Dans ce dernier cas, il est souhaitable de former les contacts 30 sous forme de bossages conducteurs localisés sur ces contacts, ou de former de tels bossages à d'autres endroits désirés de la face arrière de la puce en reliant alors ces bossages aux contacts 30 par des interconnexions formées en même temps que les contacts 30.

Les puces et les plaquettes optiques peuvent être découpées en une seule opération de découpe, sans décalage latéral et sans nécessité de procéder à une coupe au-dessous puis au-dessus de la tranche. De plus, étant donné que le cordon de scellement 26 n'a pas besoin d'être situé entre le réseau matriciel et les plages de contact CC, on peut prévoir une seule ligne de cordon de scellement entre deux lignes de puces adjacentes sur la tranche, et le sciage en microsystèmes individuels après la fin du processus de fabrication sur tranche peut se faire au milieu d'un cordon de scellement unique placé exactement entre les deux lignes de puces. La figure 7 représente la disposition de principe générale montrant les cordons de scellement 26 dont les lignes médianes HH et VV constituent les lignes de découpe des microsystèmes. Le cordon de scellement peut avoir une largeur totale de 250 micromètres environ.

On notera que dans une application d'afficheur à cristal liquide, la structure optique comprend un réseau matriciel d'électrodes sur la puce et une contre-électrode sur la plaquette optique 22, le cristal liquide étant commandé par une différence de potentiel entre une électrode du réseau matriciel et la contre-électrode formée sur la plaquette 22. Sur la figure 4, on pouvait prévoir sous la plaquette une plage de contact pour accéder électriquement à la contre-électrode, cette plage de contact étant accessible dès lors qu'elle est située dans la partie de plaquette optique ne recouvrant pas la puce 10.

Dans la structure selon l'invention, on établira avec la contre-électrode 40 une connexion électrique analogue à celles qu'on établit avec les plots de la puce, ceci de la manière représentée à la figure 8. Sur cette figure on a représenté, pour simplifier, sur la droite une des plages de contact CC sur la puce avec un via 32 à travers l'épaisseur de la puce, ce via 32 rejoignant une plage conductrice 30 à l'arrière de la puce, et sur la gauche une autre plage de contact 42 sur la face avant de la puce, recouvrant un via conducteur 44 traversant toute l'épaisseur de la puce et rejoignant une plage conductrice 46 sur la face arrière de la puce. Le via 44 est, comme le via 32, rempli de matériau conducteur. Au-dessus de la plage de contact 42, on dépose par exemple une goutte de colle conductrice 48 qui vient en contact avec la contre-électrode 40 de la plaquette 22. Ce dépôt est fait avant collages des deux tranches l'une sur l'autre. De cette manière on établit un accès électrique à la contre-électrode par l'arrière de la puce.

Globalement, le procédé de fabrication du microsystème peut se résumer de la manière suivante :

La tranche de silicium est traitée d'une manière classique par des opérations de dépôts, de gravure, de dopages, de préférence selon une technologie CMOS, pour établir le réseau matriciel RM, les circuits de commande de ce réseau, d'autre circuits annexes (convertisseurs, circuits de traitement de signaux, etc.), ainsi que les plages de contact CC.

Les trous destinés à former les vias conducteurs 32 sont faits par gravure ionique réactive, par l'arrière de la tranche de silicium, les trous à graver étant délimités par une résine photogravée selon le motif de trous à former. Pour cette photogravure, on procède à un alignement de masque de préférence en utilisant un système d'éclairement infrarouge qui traverse l'épaisseur de la puce de silicium et permet de vérifier que la position du masque de photogravure à l'arrière de la tranche semiconductrice est correcte par rapport à la position des plages de contact CC à l'avant de la tranche. Les trous peuvent aussi être réalisés par micro-usinage laser ou ultrasonique.

La gravure du silicium est arrêtée lorsque les produits de gravure atteignent les plages de contact CC, montrant que les trous ont traversé toute l'épaisseur du silicium. L'arrêt de gravure est soit automatique si le produit de gravure n'attaque pas l'aluminium des plages de contact, soit détecté par l'apparition de particules d'aluminium. L'arrêt de gravure peut aussi se faire, en technologie CMOS, sur une couche d'oxyde de silicium réalisée préalablement au dépôt métallique.

Le trou de remplissage 34 peut être constitué à cette étape ou peut être fait séparément.

Les trous sont oxydés superficiellement pour empêcher ensuite un contact électrique entre les vias conducteurs et le substrat de silicium constituant le corps de la puce.

Puis un métal (aluminium de préférence) est déposé dans les trous. Le trou de remplissage 34 est protégé à ce stade s'il a déjà été formé. Le métal déposé dans les trous est superficiel ou bien il comble les trous.

Un dépôt métallique sur toute la face arrière est fait soit simultanément avec le dépôt de métal qui précède soit dans une opération séparée. Ce dépôt est gravé pour former les contacts 30 ainsi que des interconnexions éventuelles sur la face arrière de la puce.

Le trou de remplissage 34 peut être fait à ce stade s'il ne l'a pas été auparavant.

Des bossages conducteurs sont éventuellement faits à ce stade sur la face arrière de la puce si le microsystème doit être reporté par soudage direct en surface plot contre plot sur un substrat de support. Les bossages sont en principe faits par dépôt électrolytique sur des plages conductrices de la face arrière de la puce.

Pour réaliser les contacts à travers le substrat, on peut envisager des méthodes différentes, incluant par exemple la délimitation de plots de silicium conducteur traversant toute l'épaisseur du substrat et entourés d'isolant en couronne cylindrique.

A ce stade, les opérations sur la face arrière de la puce sont terminées.

Des espaceurs ont été formés sur la face avant de la tranche de la puce ou sont formés à ce stade (espaceurs en résine ou oxyde, d'épaisseur maîtrisée) à des endroits qui ne gênent pas le fonctionnement optique.

Une couche de polyimide d'accrochage du cristal liquide peut être déposée à ce stade, notamment lorsque le cristal liquide nécessite d'être orienté selon une direction de frottement de la couche avec laquelle il est en contact (cas des cristaux nématiques twistés en particulier). Le polyimide est frotté dans la direction désirée.

Un cordon de colle de scellement (résine époxy) est déposé en lignes et en colonnes entre les puces de la tranche.

Une goutte de colle conductrice ou une bille en matériau conducteur d'un diamètre supérieur à l'épaisseur de la cavité finie est déposée au-dessus de celle des plages de contact CC qui servira au contact avec une contre-électrode de la structure optique.

La tranche de structures optiques est en pratique une simple tranche de verre revêtue d'une contre-électrode globale, délimitée ou non puce par puce, cette contre-électrode étant elle-même revêtue de polyimide frotté si la nature du cristal liquide l'exige. La tranche de structures optiques est collée sur la tranche de silicium. Le cordon de scellement assure l'étanchéité de chaque cavité et l'adhésion des tranches l'une à l'autre. Le contact avec la contre-électrode s'établit par la colle conductrice.

Le cordon de scellement est polymérisé thermiquement.

On peut alors procéder au remplissage de la cavité par du cristal liquide, après avoir fait le vide dans la cavité. Le vide est fait par pompage et étuvage pendant plusieurs heures.

Le trou de remplissage est fermé par un bouchon de colle, par exemple une colle polymérisée par ultraviolets.

On peut alors procéder à la découpe de la tranche en microsystèmes individuels, par exemple par sciage le long des lignes et des colonnes, en suivant la ligne de milieu de la largeur des cordons de scellement.

Les microsystèmes peuvent être reportés, s'il y a lieu, sur un substrat, par des techniques classiques de report (fils soudés, la puce étant alors retournée face avant en direction du substrat, mais alors il faut que le substrat soit ouvert en regard du substrat, faute de quoi la structure optique ne pourrait pas fonctionner), ou report par soudage plot contre plot lorsqu'on a fait des bossages conducteurs sur la face arrière de la puce.

L'invention est particulièrement intéressante pour les micro-afficheurs à cristaux liquides, dans lesquels les électrodes du réseau matriciel servent à la fois d'électrode de commande pour appliquer localement une différence de potentiel au cristal liquide, et de miroir optique pour réfléchir la lumière parvenant sur l'électrode à travers le cristal liquide et la renvoyer à nouveau à travers le cristal liquide. Les électrodes sont dans ce cas de préférence en aluminium.

## Revendications

1. Procédé de fabrication d'un microsystème optique à matrice électronique monolithique, dans lequel on fabrique collectivement, sur la face avant d'une tranche semiconductrice d'une épaisseur d'une ou plusieurs centaines de micromètres au moins, N réseaux matriciels (RM) de points d'image et des circuits associés à chaque réseau, pour réaliser sur cette tranche N puces électroniques monolithiques identiques (10), avec sur au moins un côté de chaque réseau (RM) un ensemble de plages de contact électrique (CC) pour la connexion de la puce correspondante avec l'extérieur, on fabrique collectivement et on place en contact étroit avec la face avant de la tranche semiconductrice une plaque servant à la constitution collective de N structures optiques de formation d'image, identiques, chaque structure optique de formation d'image (12) recouvrant une puce respective (10) et étant apte à former une image globale en correspondance avec l'ensemble du réseau matriciel de la puce respective, on ouvre à l'arrière de la tranche semiconductrice et sur toute l'épaisseur de celle-ci des trous (32) allant jusqu'aux plages de contact (CC) de la face avant, on utilise ces trous pour établir une connexion électrique conductrice avec les plages de contact à partir de la face arrière de la tranche, et, seulement après ces différentes opérations, on divise la tranche en N microsystèmes optiques individuels, la séparation entre les puces et la séparation entre les structures optiques recouvrant les puces s'effectuant selon les mêmes lignes de découpe (HH, VV).

2. Procédé selon la revendication 1, **caractérisé en ce qu'**il comporte la formation d'un cordon de scellement (26) entourant chaque puce et servant à assurer le collage de la puce avec la structure optique de formation d'image, ce cordon étant déposé en lignes et en colonnes au stade de fabrication collective, sur la tranche semiconductrice ou sur la plaque destinée à constituer les structures optiques, et **en ce que**, à la fin des étapes de fabrication collective sur tranche, la tranche et la plaque sont découpées selon des lignes et des colonnes s'étendant dans le sens des cordons de scellement en suivant le milieu de la largeur de ceux-ci.

3. Procédé selon l'une des revendications 1 et 2, destiné à la fabrication d'un micro-afficheur à cristaux liquide, du cristal liquide étant contenu dans une cavité formée entre la puce et la plaque destinée à assurer la constitution des structures optiques, **caractérisé en ce qu'**un trou de remplissage (34) est percé, pour chaque puce, dans toute l'épaisseur de la tranche semiconductrice, et **en ce que** le remplissage est effectué et un bouchon est formé dans le trou après le remplissage, avant d'opérer la séparation de la tranche et de la plaque en microsystèmes individuels.

4. Microsystème optique **caractérisé en ce qu'**il comprend l'association étroite d'une puce électronique monolithique d'une épaisseur d'une ou plusieurs centaines de micromètres, portant sur sa face avant un réseau matriciel (RM) de points d'image et des plages de contact électrique (CC), et d'une structure optique de formation d'une image globale correspondant au réseau, la structure optique comportant une plaque placée contre la face avant de la puce, avec des contacts électriques (30) à l'arrière de la puce et des vias conducteurs (32) entre ces contacts électriques de la face arrière et les plages de contact de la face avant, pour l'accès au réseau matriciel.

5. Microsystème selon la revendication 4, constituant un micro-afficheur à cristal liquide, et utilisant comme structure optique associée une cavité remplie de cristal liquide et fermée par une plaque (12) comportant une contre-électrode, le cristal liquide étant situé entre la puce et cette plaque, la puce comprenant en outre un trou (34) de remplissage de la cavité par la face arrière de la puce, s'étendant de la face arrière à la face avant de la puce, ce perçage étant fermé par un bouchon d'obturation (36).

## Claims

1. Fabrication process for an optical microsystem with monolithic electronic matrix, wherein N dot matrix arrays (RM) and circuits associated with each array are fabricated collectively, on the front of a semiconductor wafer of a thickness of at least around one hundred or several hundred microns, in order to produce on this wafer N identical monolithic electronic chips (10), with, on at least one side of each array (RM), a set of electrical contact lands (CC) for connecting the corresponding chip externally, a plate for collectively forming N identical optical image-forming structures is fabricated collectively and placed in close contact with the front of the semiconductor wafer, each optical image-forming structure (12) covering a respective chip (10) and being designed to form an overall image corresponding with the whole of the matrix array of the respective chip, holes (32) through to the contact lands (CC) on the front are opened at the back of the semiconductor wafer and through its thickness, these holes are used to establish a conductive electrical connection with the contact lands from the back of the wafer, and, only after these various operations, the wafer is divided into N individual optical microsystems, the separation between the chips and the separation between the optical structures covering the chips being carried out along the same cutting lines (HH, VV).

2. Process according to Claim 1, **characterized in that** it comprises the formation of a sealing bead (26) around each chip for bonding the chip with the optical image-forming structure, this bead being deposited in rows and columns at the collective fabrication stage, on the semiconductor wafer or on the plate intended to form the optical structures, and **in that**, at the end of the collective fabrication steps on the wafer, the wafer and the plate are cut along rows and columns extending in the direction of the sealing beads, centered widthwise along the latter.

3. Process according to one of Claims 1 or 2, intended for the fabrication of a liquid crystal microdisplay, liquid crystal being contained in a cavity formed between the chip and the plate intended to form the optical structures, **characterized in that** a filling hole (34) is made, for each chip, through the thickness of the semiconductor wafer, and **in that** the filling is carried out and a plug is formed in the hole after filling, before carrying out separation of the wafer and of the plate into individual microsystems.

4. Optical microsystem, **characterized in that** it comprises the close association of a monolithic electronic chip of a thickness of one or more hundred microns, bearing on its front a dot matrix array (RM) and electrical contact lands (CC), and of an optical structure for forming an overall image corresponding to the array, the optical structure comprising a plate placed against the front of the chip, with electrical contacts (30) on the back of the chip and conductive vias (32) between these electrical contacts on the back and the contact lands on the front, for access to the matrix array.

5. Microsystem according to Claim 4, forming a liquid crystal microdisplay and using as associated optical structure a cavity filled with liquid crystal and sealed by a plate (12) comprising a back electrode, the liquid crystal being situated between the chip and this plate, the chip further comprising a hole (34) for filling the cavity from the back of the chip, extending from the back to the front of the chip, this hole being sealed by a plug (36).

## Patentansprüche

1. Verfahren zum Herstellen eines optischen Mikrosystems mit elektronischer Festkörpermatrix, bei dem man gemeinsam auf der Vorderseite eines Halbleiterwafers mit einer Stärke von mindestens ein oder mehreren Hundert Mikrometer N Matrixnetze (RM) aus Bildpunkten und zu jedem Netz gehörende Schaltungen herstellt, um auf diesem Wafer N identische Festkörperchips (10) herzustellen, mit auf mindestens einer Seite jedes Matrixnetzes (RM) einer Einheit elektrischer Kontaktbereiche (CC) zum Verbinden des entsprechenden Chips mit der Außenseite, bei dem man gemeinsam eine Platte, die zum gemeinsamen Bilden N optischer identischer Bildformungsstrukturen dient, herstellt und in engem Kontakt mit der Vorderseite des Halbleiterwafers anordnet, wobei jede optische Bildformungsstruktur (12) einen jeweiligen Chip (10) bedeckt und ein globales Bild in Übereinstimmung mit der Einheit des Matrixnetzes des jeweiligen Chips bilden kann, und bei dem man auf der Rückseite des Halbleiterwafers und auf seiner ganzen Stärke Bohrungen (32) öffnet, die bis zu den Kontaktbereichen (CC) der Vorderseite reichen, man diese Bohrungen verwendet, um eine elektrisch leitende Verbindung mit den Kontaktbereichen ausgehend von der Rückseite zu erstellen und erst nach diesen verschiedenen Operationen den Wafer in N einzelne optische Mikrosysteme teilt, wobei die Trennung zwischen den Chips und die Trennung zwischen den optischen Strukturen, die die Chips abdecken, entlang den gleichen Schneidlinien (HH, VV) erfolgen.

2. Verfahren nach Anspruch 1, **dadurch gekennzeichnet, dass** es das Bilden einer Abdichtwulst (26) aufweist, die jeden Chip umgibt und dazu dient, das Kleben des Chips auf der optischen Bildformungsstruktur sicherzustellen, wobei dieser Wulst in Zeilen und Spalten im Stadium des gemeinsamen Herstellens auf dem Halbleiterwafer oder auf der Platte, die dazu bestimmt ist, die optischen Strukturen zu bilden, aufgebracht wird, und dass am Ende der Schritte der gemeinsamen Herstellung auf dem Wafer der Wafer und die Platte entlang den Zeilen und Spalten geschnitten werden, die sich in die Richtung der Abdichtwülste entlang der Mitte der Breite dieser erstrecken.

3. Verfahren nach einem der Ansprüche 1 und 2, das zum Herstellen eines Flüssigkristall-Mikrodisplays bestimmt ist, wobei Flüssigkeitskristall in einem Hohlraum enthalten ist, der zwischen dem Chip und der Platte, die dazu bestimmt ist, das Bilden der optischen Strukturen sicherzustellen, ausgebildet ist, **dadurch gekennzeichnet, dass** eine Füllbohrung (34) für jeden Chip in der ganzen Stärke des Halbleiterwafer gebohrt wird, und dass das Füllen erfolgt und ein Stopfen in der Bohrung nach dem Füllen ausgebildet wird, bevor das Trennen des Wafers und der Platte in einzelne Mikrosysteme vorgenommen wird.

4. Optisches Mikrosystem, **dadurch gekennzeichnet, dass** es die enge Verbindung eines elektronischen Festkörperchips mit einer Stärke von ein bis mehreren Hundert Mikrometer, der auf seiner Vorderseite ein Matrixnetz (RM) aus Bildpunkten und elektrische Kontaktbereiche (CC) trägt, mit einer optischen Struktur zum Bilden eines globalen Bilds, das dem Netz entspricht, aufweist, wobei die optische Struktur, die eine Platte aufweist, gegen die Vorderseite des Chips angeordnet ist, mit elektrischen Kontakten (30) auf der Rückseite des Chips und leitenden Bohrungen (32) zwischen diesen elektrischen Kontakten der Rückseite und den Kontaktbereichen auf der Vorderseite für den Zugang zu dem Matrixnetz.

5. Mikrosystem nach Anspruch 4, das ein Flüssigkristall-Mikrodisplay bildet und als dazu gehörende optische Struktur einen Hohlraum verwendet, der mit Flüssigkristall gefüllt und mit einer Platte (12), die eine Gegenelektrode aufweist, verschlossen ist, wobei der Flüssigkristall zwischen dem Chip und dieser Platte liegt, wobei der Chip ferner eine Bohrung (34) zum Füllen des Hohlraums von der Rückseite des Chips her aufweist, die sich von der Rückseite zur Vorderseite des Chips erstreckt, wobei diese Bohrung durch einen Verschlussstopfen (36) verschlossen ist.
